# EUROPÄISCHE PATENTSCHRIFT

(11) **EP 1 105 877 B1**
(45) Veröffentlichungstag und Bekanntmachung des Hinweises auf die Patenterteilung: **22.10.2003**
(21) Anmeldenummer: 99953560.2
(22) Anmeldetag: 20.08.1999
(51) Int. Cl.: G11C 7/10

(54) **SPEICHERSYSTEM**
MEMORY SYSTEM
SYSTEME MEMOIRE

(30) Priorität: 26.08.1998 DE 19838813
(43) Veröffentlichungstag der Anmeldung: 13.06.2001
(73) Patentinhaber: Infineon Technologies AG, 81669 München (DE)
(72) Erfinder: MIERSCH, Ekkehard, D-71101 Schönaich (DE); MUFF, Simon, D-93049 Regensburg (DE); POHL, Jens, D-93170 Bernhardswald (DE)
(74) Vertreter: Hermann, Uwe, Dipl.-Ing.
(86) Internationale Anmeldenummer: DE9902626
(87) Internationale Veröffentlichungsnummer: WO00013185

(56) Entgegenhaltungen:
- US-A- 5 128 941
- US-A- 5 440 522
- US-A- 5 737 761

## Beschreibung

Die Erfindung betrifft ein Speichersystem mit Datenleitungen zur Übermittlung von Daten zwischen Speicherbausteinen und wenigstens einer Steuereinheit.

Die US-Patentschrift 5 128 941 offenbart ein Speichersystem mit einer Zentral-Steuereinheit, die über eine erste Datenleitung mehrere Speicherbausteine, die an einem Datenbus angeschlossen sind, ansteuert. Eine Adressierung eines Speicherbausteins erfolgt dabei über alle Datenleitungen, wobei eine Pufferschaltung die Leitungskapazität treibt.

In der US-Patentschrift US 5 440 522 ist ein vergleichbares Speichersystem offenbart, bei dem zwischen Speicherbausteingruppen und einem Datenbus Treiberschaltungen vorgesehen sind.

Weitere bekannte Speichersysteme weisen eine Schnittstelleneinheit auf, die eine Zentral-Steuereinheit und Datenleitungen enthält. Die Datenleitungen befinden sich mit Kontrolleitungen in einem Bus-System, durch das Speicherbausteine quasiparallel geschaltet sind.

Die bekannten Speichersysteme weisen den Nachteil auf, dass die Zugriffszeit mit zunehmender Speichergröße gleichfalls zunimmt.

Der Erfindung liegt die Aufgabe zugrunde, die Nachteile des Standes der Technik zu vermeiden. Insbesondere soll ein gattungsgemäßes Speichersystem so ausgestaltet werden, dass die Zugriffszeit auf in den Speicherbausteinen enthaltene Daten möglichst kurz ist.

Erfindungsgemäß wird diese Aufgabe dadurch gelöst, daß ein Speichersystem mit Datenleitungen zur Übermittlung von Daten zwischen Speicherbausteinen und wenigstens einer Steuereinheit vorgesehen ist, wobei das Speichersystem wenigstens eine Zentral-Steuereinheit und wenigstens eine Gruppen-Steuereinheit aufweist, wobei die Gruppen-Steuereinheit wenigstens eine erste Datenleitung zum Anschluß der Gruppen-Steuereinheit an die Zentral-Steuereinheit und zweite Datenleitungen zum Anschluß einer Gruppe von zumindest zwei Speicherbausteinen an die Gruppen-Steuereinheit aufweist, wobei eine Adressierung nur die ersten und zweiten Datenleitungen zum adressierten Speicherbaustein aktiv auswählt.

Die Erfindung sieht also vor, ein Speichersystem zu schaffen, das einen hierarchisch organisierten Zugriff auf Daten in einzelnen Speicherbausteinen ermöglicht.

Zwischen den Speicherbausteinen und der Zentral-Steuereinheit ist wenigstens eine weitere Steuereinheit angeordnet.

Einer der Gegenstände der Erfindung ist somit eine Realisierung einer neuen Organisationsform der Speicherbausteine. Hierbei werden Speicherbausteine in m Gruppen von Speicherbausteinen aufgeteilt. Über geeignete Bauelemente, insbesondere Verstärker wie Buffer oder Repeater, werden die Speicherbausteine elektrisch voneinander getrennt.

Die Zentral-Steuereinheit ist an M = m * x Datenleitungen angeschlossen, wobei x die Anzahl der Datenleitungen zu den einzelnen Speicherbausteinen bezeichnet. Der Datenpfad zwischen der Zentral-Steuereinheit und einer Prozessor-Einheit, wie einer CPU (Central Processor Unit) weist gleichfalls M = m * x Datenleitungen auf.

Eine Ansteuerung einer noch größeren Anzahl von Speicherbausteinen durch die Zentral-Steuereinheit wird zweckmäßigerweise dadurch realisiert, daß die zweiten Datenleitungen mit wenigstens einer Teilgruppen-Steuereinheit verbunden sind und daß der Anschluß der Speicherbausteine über die Zentral-Steuereinheit, die erste Datenleitung, die Gruppen-Steuereinheit, die zweiten Datenleitungen, die Teilgruppen-Steuereinheit und über dritte Datenleitungen erfolgt, wobei die dritten Datenleitungen die Speicherbausteine mit der Teilgruppen-Steuereinheit verbinden.

Diese besonders vorteilhafte Ausführung des Speichersystems sieht also vor, wenigstens drei Hierarchieebenen der Anschlüsse für die Speicherbausteine zu schaffen.

Hierdurch wird ein Speichersystem für eine große Anzahl von Speicherbausteinen geschaffen.

Grundsätzlich ist es für die Durchführung der Erfindung nur erforderlich, daß zusätzlich zu der Zentral-Steuereinheit wenigstens eine Gruppen-Steuereinheit vorhanden ist. Jedoch wird die Effizienz der Speichersystems durch eine größere Anzahl von Gruppen-Steuereinheiten erhöht.

Zusätzlich zu den besonders zweckmäßigen Teilgruppen-Steuereinheiten vorgesehene weitere Steuereinheiten, die zusätzliche Hierarchieebenen anschließen, ermöglichen es, mehrere hundert Speicherbausteine anzuschließen. Eine derart größere Anzahl von Hierarchieebenen und verschiedenen Steuereinheiten ist vor allen Dingen bei einer besonders großen Anzahl von Speicherbausteinen zweckmäßig. Besonders schnelle Zugriffszeiten lassen sich dadurch realisieren, daß die Datenleitungen galvanisch voneinander getrennt sind und durch die Steuereinheit, an der sie angeschlossen sind, nur in ausgewählten Schaltzuständen elektrisch verbunden werden.

Bei dem besonders vorteilhaften Speichersystem mit wenigstens einer Teilgruppen-Steuereinheit ist es daher zweckmäßig, daß die dritten Datenleitungen durch die Teilgruppen-Steuereinheit elektrisch voneinander getrennt sind. Eine besonders bevorzugte Ausführungsform des Speichersystems zeichnet sich dadurch aus, daß die dritten Datenleitungen sternförmig von der Teilgruppen-Steuereinheit ausgehen.

Es ist gleichfalls zweckmäßig, daß die zweiten Datenleitungen durch die Gruppen-Steuereinheit elektrisch voneinander getrennt sind.

Eine gleichfalls bevorzugte Ausführungsform des Speichersystems zeichnet sich dadurch aus, daß die zweiten Datenleitungen sternförmig von der Gruppen-Steuereinheit ausgehen.

Es ist besonders zweckmäßig, daß das Speichersystem mehrere erste Datenleitungen aufweist, und daß die ersten Datenleitungen durch die Gruppen-Steuereinheit elektrisch voneinander getrennt sind.

Eine weitere bevorzugte Ausführungsform des Speichersystems zeichnet sich dadurch aus, daß die ersten Datenleitungen sternförmig von der Gruppen-Steuereinheit ausgehen.

Es ist besonders zweckmäßig, daß mit den Datenleitungen ein bidirektionaler Datenaustausch zwischen der Zentral-Steuereinheit und den einzelnen Speicherbausteinen in Zwei-Punkt-Netzen realisiert wird. Hierbei handelt es sich um Zwei-Punktleitungen mit bidirektionalen Treiber- beziehungsweise Receiver-Schaltkreisen. Über die Wahl des Innenwiderstandes des jeweils aktiven der beiden bidirektionalen Treiber- beziehungsweise Receiver-Schaltkreise der Zwei-Punktleitung kann das Leitungssystem stets aktiv mit seinem Wellenwiderstand geschlossen werden. Somit werden von einem offenen, das heißt einem aktiven Treiber fernen Ende der Leitung reflektierte Signale, die zum Treiber zurücklaufen, absorbiert. Dies gilt für die Treiber auf beiden Seiten des bidirektionalen Netzes, wobei sich der dem aktiven Treiber gegenüberliegende Treiber in einem hochohmigen Zustand befindet.

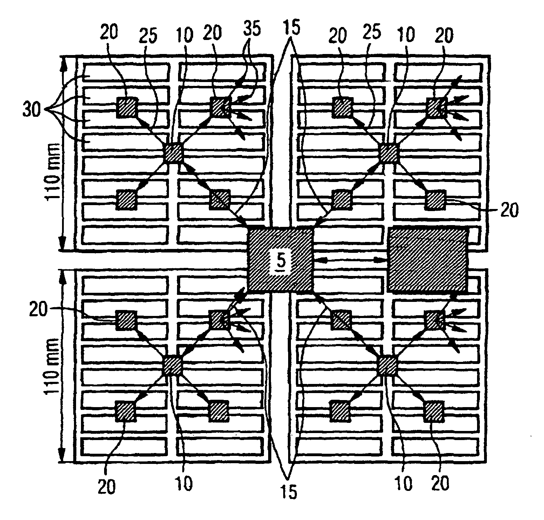

Weitere Vorteile, Besonderheiten und zweckmäßige Weiterbildungen der Erfindung ergeben sich aus der nachfolgenden Darstellung eines bevorzugten Ausführungsbeispiels anhand der Zeichnung.

Die Zeichnung zeigt eine Aufsicht auf ein Speichersystem mit einer Zentral-Steuereinheit 5, die mit Gruppen-Steuereinheiten 10 über erste Datenleitungen 15 verbunden ist.

Die Gruppen-Steuereinheiten 10 sind mit Teilgruppen-Steuereinheiten 20 über zweite Datenleitungen 25 verbunden.

Die Teilgruppen-Steuereinheiten 20 sind mit Speicherbausteinen 30 über dritte Datenleitungen 35 verbunden.

Eine besonders gute Raumausnutzung läßt sich dadurch erzielen, daß die Zentral-Steuereinheit 5 von vier Gruppen-Steuereinheiten 10 umgeben ist, und daß die Gruppen-Steuereinheiten 10 ihrerseits durch jeweils vier Teilgruppen-Steuereinheiten 20 mit den daran angeschlossenen Speicherbausteinen 30 umgeben sind. Die Speicherbausteine enthalten jeweils eine Vielzahl von Zellenfeldern.

Durch die Teilgruppen-Steuereinheit 20 und die an ihnen angeschlossenen Speicherbausteine 30 werden Speichermodule gebildet. Die Speichermodule enthalten vorzugsweise vier Träger für Speicherbausteine. Die Träger für Speicherbausteine enthalten bei einer einseitigen Bestückung vorzugsweise einen und bei einer beidseitigen Bestückung vorzugsweise zwei Speicherbausteine.

Eine Adressierung erfolgt über ein Signal, das jedem der Zellenfelder eines Speicherbausteins zugewiesen ist. Die Adressierung des Speicherbausteins wird so gesteuert, daß nur der spezielle Datenpfad zu dem speziellen Speicherbaustein durch eine Chip-Selektierungs-Adresse (chip-select-address) aktiv ausgewählt wird, auf dem gemäß einer Speicherorganisation die Dateninformation liegt und der das Ziel der speziellen Adresse ist.

Die Datenleitung, das heißt der durch sie realisierte Datenpfad, weist x Datenbits auf, wobei x beispielsweise 18 beträgt.

Das Speichersystem weist den weiteren Vorteil auf, daß eine Hinzufügung von weiteren Speicherbausteinen bei einer Speichererweiterung ohne Einfluß auf die Zugriffszeit zu den Daten der einzelnen Speicherbausteine erfolgt.

Die Zugriffszeit ist alleine durch den in einer Maximalkonfiguration festgelegten Pfad zwischen der Zentral-Steuereinheit und dem Speicherbaustein gegeben.

Die Zugriffszeit auf jeden der Speicherbausteine wird bestimmt durch die Signallaufzeit auf den eingesetzten Datenleitungen 15, 25 und 35, durch die Schaltzeiten der Zentral-Steuereinheit und der zugehörigen Gruppen-Steuereinheit beziehungsweise Teilgruppen-Steuereinheit sowie durch die Datenzugriffszeit auf die Speicherbausteine. Daher hängt die Zugriffszeit im wesentlichen lediglich von der Anzahl von durch die Steuereinheiten gebildeten Hierachieebenen ab, nicht jedoch von der Anzahl der Speicherbausteine.

Auch bei einer nicht maximalen Konfiguration, das heißt bei einer lediglich teilweise erfolgten Belegung des Speichersystems mit Speicherbausteinen 30, ist das erfindungsgemäße Speichersystem erheblich schneller als die bekannten Speichersysteme. Dies gilt insbesondere dann, wenn es sich um Hauptspeicher mit einer großen Anzahl von Speicherbausteinen 30 handelt.

Die Teilgruppen-Steuereinheiten 20 sind vorzugsweise als Buffer-Chips ausgebildet und weisen eine Datenbreite von x bits auf. Die Teilgruppen-Steuereinheiten adressieren bs Chipträger. Wenn jeder der Chipträger doppelseitig mit insgesamt zwei Speicherbausteinen bestückt ist, adressiert die Teilgruppen-Steuereinheit 20 bs Speicherbausteine 30. Es ist zwar auch möglich, daß die Teilgruppen-Steuereinheit 20 mehr als 1 * bs, beziehungsweise im Falle einer doppelseitigen Belegung der Chipträger zwei bs Speicherbausteine 30 ansteuert, jedoch würde dieses dazu führen, daß an einem gemeinsamen Bus mehrere Speicherbausteine in Reihe geschaltet sind. Ein weitgehendes Weglassen einer derartigen Reihenschaltung ist jedoch zur Vermeidung von störenden Reflexionen an nicht aktivierten Speicherbausteinen vorteilhafter.

Es ist vorteilhaft, daß von jeder Teilgruppen-Steuereinheit 20 mit B Datentreibern nur x Datentreiber aktiviert werden, wobei gilt: B = b * x, wobei vorzugsweise gilt: b = bs + 1 und bs vorzugsweise gleich 4 ist, so daß sich ergibt: b = 5. In diesem Fall werden somit 18 Datentreiber plus zugehörigen Kontrolltreibern aktiviert. Die Anzahl b ist vorzugsweise deshalb um eins größer als bs, weil zusätzlich ein Taktsignal (clock) übertragen wird.

Im dargestellten Fall mit 16 Teilgruppen-Steuereinheiten und 4 Gruppen-Steuereinheiten 10 werden durch die Zentral-Steuereinheit 5 insgesamt 128 Speicherbausteine 30 adressiert. Die Zahl 128 ergibt sich daraus, daß 16 Teilgruppen-Steuereinheiten 20 jeweils 8 Speicherbausteine, das heißt insgesamt 128 Speicherbausteine 30, ansteuern.

Zur Ansteuerung von 128 Speicherbausteinen 30 werden insgesamt 21 Steuereinheiten, das heißt eine Zentral-Steuereinheit 5, vier Gruppen-Steuereinheiten 10 und 16 Teilgruppen-Steuereinheiten 20 benötigt. Vorzugsweise sind nicht nur die Teilgruppen-Steuereinheiten 20, sondern auch die Zentral-Steuereinheit 5 und die Gruppen-Steuereinheiten 10 als Buffer-Chips ausgebildet.

Eine derartige Anordnung ist vor allen Dingen dann zweckmäßig, wenn mit verhältnismäßig einfach herstellbaren Speicherbausteinen eine möglichst große Speicherkapazität des gesamten Speichersystems erzielt werden soll. So können im Fall von Speicherbausteinen 30, die jeweils eine Speicherkapazität von 72 Mbit aufweisen, insgesamt 4,096 Gbytes = 4 * 16 * 4 * 2 * 72 Mbit adressiert werden. Mit bs = 4 und einer direkten binären Implementierung wären 7 zusätzliche Adressleitungen erforderlich.

In dem Fall, daß die einzelnen Speicherbausteine 30 eine größere Speicherkapazität, beispielsweise 288 Mbit aufweisen, ist eine Anordnung der Speicherbausteine in einem Speichersystem, das lediglich eine Zentral-Steuereinheit 5 und Gruppen-Steuereinheiten 10 aufweist, zweckmäßiger. In diesem Fall werden 4 * 16 * 1 * 2 = 128 * 288 Mbit = 4,096 GBytes durch lediglich eine Zentral-Steuereinheit 5 und vier Gruppen-Steuereinheiten 10 angesteuert. Eine Schnittstelleneinheit des Speichersystems ist so gestaltet, daß sowohl Daten, womit die gespeicherten Informationen gemeint sind, als auch Kontrollsignale übertragen werden. Die Kontrollsignale ermöglichen ein Abspeichern der Daten und umfassen die Adressen, die Taktsignale und Chip-Selektierungs-Signale (chip-select-signal) und damit entsprechende Pfad-Selektierungs-Signale.

Im dargestellten Fall weist die Zentral-Steuereinheit 5 einen 72 bit Datenbus auf, der auf m = 4 Datenbussen von jeweils x = 18 bit für jede der m = 4 Speicherchip-Gruppen zusammengesetzt ist.

Die Gruppen-Steuereinheiten 10 weisen hingegen einen Datenbus mit einer Datenbreite von lediglich 18 bit auf.

Somit ist ein breiter Datenbus nur zwischen der Zentral-Steuereinheit 5 und einer zentralen Prozessoreinheit (CPU) erforderlich.

Die genannten Werte für m, b, bs, x sind lediglich beispielhaft genannt und beziehen sich auf die dargestellte, besonders vorteilhafte Ausführungsform des Speichersystems.

Hiermit ist ein beispielsweise in der Zentral-Steuereinheit 5 einprogrammiertes Adressierungsschema verwirklicht, bei dem innerhalb einer Gruppe von Speicherbausteinen 30 am Ende einer Datenleitung 35 jeweils ein Speicherbaustein 30 - aus maximal zwei Speicherbausteinen 30, die auf demselben Chipträger montiert sind - selektiert wird. Damit wird nur eine Treibergruppe der Full-Buffer-Chips gestaltet, nämlich die, welche direkt im Datenpfad zu dem selektierten Speicherbaustein liegt. Hierdurch werden nicht im Datenpfad liegende Treibergruppen sowie ihre Kontrollsignale vom Schalten ausgenommen, ebenso wie Steuereinheiten, die zwar in der Gruppe der Speicherbausteine 30 liegen, nicht jedoch im direkten Pfad zu dem ausgewählten Speicherbaustein 30. Das Adressierungsschema minimiert damit nicht nur die Zahl der für einen Speicherbaustein 30 schaltenden Treiber, sondern auch die Anzahl der Buffer-Chips und Speicherbausteine, die pro Zugriff auf einen Speicher schalten und minimiert damit auch den Energiebedarf und die Wärmeerzeugung des Speichersystems.

Eine derartige Leitungskonzeption erlaubt im Gegensatz zu den im Stand der Technik bekannten Leitungen mit Multi-Stub-Bussystem eine Datenübertragung mit der Gruppenlaufzeit der Signale.

## Patentansprüche

1. Speichersystem mit Datenleitungen (15, 25, 35) zur Übermittlung von Daten zwischen Speicherbausteinen (30) und wenigstens einer Steuereinheit (5, 10, 20), wobei das Speichersystem wenigstens eine Zentral-Steuereinheit (5) und wenigstens eine Gruppen-Steuereinheit (10) aufweist, wobei die Gruppen-Steuereinheit (10) wenigstens eine erste Datenleitung (15) zum Anschluß der Gruppen-Steuereinheit (10) an die Zentral-Steuereinheit (5) und zweite Datenleitungen (25) zum Anschluß einer Gruppe von zumindest zwei Speicherbausteinen (30) an die Gruppen-Steuereinheit (10) aufweist, wobei eine Adressierung nur die ersten und zweiten Datenleitungen (15, 25) zum adressierten Speicherbaustein (30) aktiv auswählt.

2. Speichersystem nach Anspruch 1, **dadurch gekennzeichnet, daß** die zweiten Datenleitungen (25) mit wenigstens einer Teilgruppen-Steuereinheit (20) verbunden sind und daß der Anschluß der Speicherbausteine (30) über die Zentral-Steuereinheit (5), die erste Datenleitung (15), die Gruppen-Steuereinheit (10), die zweiten Datenleitungen (25), die Teilgruppen-Steuereinheit (20) und über dritte Datenleitungen (35) erfolgt, wobei die dritten Datenleitungen (35) die Speicherbausteine (30) mit der Teilgruppen-Steuereinheit (20) verbinden.

3. Speichersystem nach Anspruch 2, **dadurch gekennzeichnet, daß** die dritten Datenleitungen (35) durch die Teilgruppen-Steuereinheit (20) elektrisch voneinander getrennt sind.

4. Speichersystem nach Anspruch 3, **dadurch gekennzeichnet, daß** die dritten Datenleitungen (35) sternförmig von der Teilgruppen-Steuereinheit (20) ausgehen.

5. Speichersystem nach einem der Ansprüche 1 bis 4, **dadurch gekennzeichnet, daß** die zweiten Datenleitungen (25) durch die Gruppen-Steuereinheit (10) elektrisch voneinander getrennt sind.

6. Speichersystem nach einem der Ansprüche 1 bis 5, **dadurch gekennzeichnet, daß** die zweiten Datenleitungen (25) sternförmig von der Gruppen-Steuereinheit (10) ausgehen.

7. Speichersystem nach einem der Ansprüche 1 bis 6, **dadurch gekennzeichnet, daß** das Speichersystem mehrere erste Datenleitungen (15) aufweist und daß die ersten Datenleitungen (15) durch die Gruppen- Steuereinheit (10) elektrisch voneinander getrennt sind.

8. Speichersystem nach Anspruch 7, **dadurch gekennzeichnet, daß** die ersten Datenleitungen (15) sternförmig von der Gruppen-Steuereinheit (10) ausgehen.

9. Speichersystem nach einem der Ansprüche 2 bis 8, **dadurch gekennzeichnet, daß** die Teilgruppen-Steuereinheit (20) einen Full-Buffer-Chip enthält oder durch einen Full-Buffer-Chip gebildet ist.

10. Speichersystem nach einem der Ansprüche 1 bis 9, **dadurch gekennzeichnet, daß** die Gruppen-Steuereinheit (10) einen Full-Buffer-Chip enthält oder durch einen Full-Buffer-Chip gebildet ist.

11. Speichersystem nach einem der Ansprüche 1 bis 10, **dadurch gekennzeichnet, daß** die Zentral-Steuereinheit (5) einen Full-Buffer-Chip enthält oder durch einen Full-Buffer-Chip gebildet ist.

## Claims

1. Memory system having data lines (15, 25, 35) for transmitting data between memory chips (30) and at least one control unit (5, 10, 20), the memory system having at least one central control unit (5) and at least one group control unit (10), the group control unit (10) having at least one first data line (15) for connecting the group control unit (10) to the central control unit (5), and second data lines (25) for connecting a group of at least two memory chips (30) to the group control unit (10), an addressing selecting as active only the first and second data lines (15, 25) to the addressed memory chip (30).

2. Memory system according to Claim 1, **characterized in that** the second data lines (25) are connected to at least one subgroup control unit (20), and **in that** the memory chips (30) are connected via the central control unit (5), the first data line (15), the group control unit (10), the second data lines (25), the subgroup control unit (20), and via third data lines (35), the third data lines (35) connecting the memory chips (30) to the subgroup control unit (20).

3. Memory system according to Claim 2, **characterized in that** the third data lines (35) are electrically isolated from one another by the subgroup control unit (20).

4. Memory system according to Claim 3, **characterized in that** the third data lines (35) leave the subgroup control unit (20) in a star form.

5. Memory system according to one of Claims 1 to 4, **characterized in that** the second data lines (25) are electrically isolated from one another by the group control unit (10).

6. Memory system according to one of Claims 1 to 5, **characterized in that** the second data lines (25) leave the group control unit (10) in a star form.

7. Memory system according to one of Claims 1 to 6, **characterized in that** the memory system has a plurality of first data lines (15), and **in that** the first data lines (15) are electrically isolated from one another by the group control unit (10).

8. Memory system according to Claim 7, **characterized in that** the first data lines (15) leave the group control unit (10) in a star form.

9. Memory system according to one of Claims 2 to 8, **characterized in that** the subgroup control unit (20) contains a full buffer chip or is formed by a full buffer chip.

10. Memory system according to one of Claims 1 to 9, **characterized in that** the group control unit (10) contains a full buffer chip or is formed by a full buffer chip.

11. Memory system according to one of Claims 1 to 10, **characterized in that** the central control unit (5) contains a full buffer chip or is formed by a full buffer chip.

## Revendications

1. Système de mémoire comportant des lignes de données (15, 25, 35) destinées à transmettre des données entre des modules de mémoire (30) et au moins une unité de commande (5, 10, 20), le système de mémoire présentant au moins une unité de commande centrale (5) et au moins une unité de commande de groupe (10), l'unité de commande de groupe présentant au moins une première ligne de données (15) pour raccorder l'unité de commande de groupe (10) à l'unité de commande centrale (5) et des deuxièmes lignes de données (25) pour raccorder un groupe d'au moins deux modules de mémoire (30) à l'unité de commande de groupe (10), un adressage ne sélectionnant activement que les premiers et les deuxièmes lignes de données (15, 25) allant au module de mémoire (30) adressé.

2. Système de mémoire selon la revendication 1, **caractérisé en ce que** les deuxièmes lignes de données (25) sont reliées à au moins une unité de commande de sous-groupe (20) et que le raccordement des modules de mémoire (30) est réalisé par l'intermédiaire de l'unité de commande centrale (5), de la première ligne de données (15), de l'unité de commande de groupe (10), des deuxièmes lignes de données (25), de l'unité de commande de sous-groupe (20) et de troisièmes lignes de données (35), les troisièmes lignes de données (35) reliant les modules de mémoire (30) aux unités de commande de sous-groupe (20).

3. Système de mémoire selon la revendication 2, **caractérisé en ce que** les troisièmes lignes de données (35) sont électriquement séparées les unes des autres par l'unité de commande de sous-groupe (20).

4. Système de mémoire selon la revendication 3, **caractérisé en ce que** les troisièmes lignes de données (35) partent en étoile de l'unité de commande de sous-groupe (20).

5. Système de mémoire selon l'une des revendications 1 à 4, **caractérisé en ce que** les deuxièmes lignes de données (25) sont électriquement séparées les unes des autres par l'unité de commande de groupe (10).

6. Système de mémoire selon l'une des revendications 1 à 5, **caractérisé en ce que** les deuxièmes lignes de données (25) partent en étoile de l'unité de commande de groupe (10).

7. Système de mémoire selon l'une des revendications 1 à 6, **caractérisé en ce que** le système de mémoire présente plusieurs premières lignes de données (15) et que les premières lignes de données (15) sont électriquement séparées les unes des autres par l'unité de commande de groupe (10).

8. Système de mémoire selon la revendication 7, **caractérisé en ce que** les premières lignes de données (15) partent en étoile de l'unité de commande de groupe (10).

9. Système de mémoire selon l'une des revendications 2 à 8, **caractérisé en ce que** l'unité de commande de sous-groupe (20) comprend une puce de remplissage tampon ou est formée par une puce de remplissage tampon.

10. Système de mémoire selon l'une des revendications 1 à 9, **caractérisé en ce que** l'unité de commande de groupe (10) comprend une puce de remplissage tampon ou est formée par une puce de remplissage tampon.

11. Système de mémoire selon l'une des revendications 1 à 10, **caractérisé en ce que** l'unité de commande centrale (5) comprend une puce de remplissage tampon ou est formée par une puce de remplissage tampon.
